# EUROPEAN PATENT APPLICATION

(11) **EP 2 224 533 A1**
(43) Date of publication of application: **01.09.2010**
(21) Application number: 08839516.5
(22) Date of filing: 26.09.2008
(51) Int. Cl.: H01M 14/00, H01L 31/04

(54) **PIGMENT SENSITIZING PHOTOELECTRIC CONVERSION ELEMENT, AND ITS MANUFACTURING METHOD**

(30) Priority: 19.10.2007 JP 2007272011
(71) Applicant: Sony Corporation, Tokyo 108-0075 (JP)
(72) Inventor: MOROOKA, Masahiro, Tokyo 108-0075 (JP); SUZUKI, Yusuke, Tokyo 108-0075 (JP); YONEYA, Reiko, Tokyo 1080075 (JP)
(74) Representative: Horner, David Richard
(86) International application number: PCT/JP2008/067409
(87) International publication number: WO 2009/050995

(57) **Abstract**

A method of manufacturing a dye-sensitized photoelectric conversion device is provided by which a dye-sensitized photoelectric conversion device being excellent in strength and durability and free of any projection, as a result of the absence of need for an end seal, can be fabricated through simple manufacturing steps. In manufacturing a dye-sensitized photoelectric conversion device which has an electrolyte between a dye-sensitized semiconductor layer and a counter electrode and which also has a first armor member provided on the outside of the dye-sensitized semiconductor layer and a second armor member provided on the outside of the counter electrode, a sealing material and the electrolyte are formed at predetermined locations of one or both of the first armor member and the second armor member, thereafter the first armor member and the second armor member, with the sealing material and the electrolyte sandwiched therebetween, are adhered to each other with the sealing material under a gas pressure of not higher than the atmospheric air pressure and not lower than the vapor pressure of the electrolyte.

## Description

### Technical Field

The present invention relates to a dye-sensitized photoelectric conversion device and a method of manufacturing the same, suitable for application to, for example, a dye-sensitized solar cell using a dye-sensitized semiconductor layer which includes semiconductor particulates with a dye supported thereon.

### Background Art

It is said that when a fossil fuel such as coal and petroleum is used as an energy source, the resulting carbon dioxide leads to global warming. Besides, the use of atomic energy is attended by the risk of radioactive contamination. As the environmental issues are much talked about at present, dependence on these kinds of energy involves many problems.

On the other hand, the solar cell functioning as a photoelectric conversion device for converting the sunlight into electric energy uses the sunlight as an energy source. Therefore, the solar cell has very little influence on the global environments, and is therefore expected to be used more widely.

There are a wide variety of materials used to fabricate solar cells, and many solar cells using silicon are commercialized. The solar cells using silicon are largely classified into crystalline silicon solar cells using single-crystalline or polycrystalline silicon and amorphous silicon solar cells. Hitherto, single crystalline silicon or polycrystalline silicon, i.e., crystalline silicon has often been used for solar cells.

However, although the crystalline silicon solar cells are superior to the amorphous silicon solar cells in photoelectric conversion efficiency, which represents the performance of converting the light (solar) energy into electrical energy, the crystalline silicon solar cells are low in productivity and disadvantageous on a cost basis because much energy and time are needed for crystal growth.

In addition, although the amorphous silicon solar cells are characterized by higher light absorption properties, a wider range of substrate choice and an easier increase in area as compared with the crystalline silicon solar cells, the amorphous silicon solar cells are inferior to the crystalline silicon solar cells in photoelectric conversion efficiency. Further, though the amorphous silicon solar cells are higher in productivity than the crystalline silicon solar cells, the production of the amorphous silicon solar cells needs a vacuum process, like in manufacturing the crystalline silicon solar cells, so that the cost of equipment is still high.

On the other hand, toward a further lowering in the cost of solar cells, many researches have been conducted on solar cells which use organic materials in place of silicon materials. Such solar cells, however, have very low photoelectric conversion efficiencies of 1% or below and are unsatisfactory in durability.

In the foregoing circumstances, an inexpensive solar cell using semiconductor particulates sensitized by a dye (coloring matter) was reported (see Nature, 353, pp. 737 to 740, 1991). This solar cell is a wet-type solar cell, or elecrtrochemical photovoltatic cell, in which a porous thin film of titanium oxide spectrally sensitized by use of a ruthenium complex as a sensitizing dye is used as a photo-electrode. The dye-sensitized solar cell is advantageous in that inexpensive titanium oxide can be used, the light absorption of the sensitizing dye covers a wide range of visible wavelength region of up to 800 nm, the quantum efficiency of photoelectric conversion is high, and that a high energy conversion efficiency can be realized. In addition, this solar cell can be fabricated without need for a vacuum process and, hence, without need for a large equipment or the like.

The dye-sensitized solar cells in the past have a structure in which a space between two substrates is filled with a liquid electrolyte. Besides, the dye-sensitized solar cells are often manufactured by a method in which one of the substrates is provided with a feed port for injection of the electrolyte, a solution of the electrolyte is injected through the feed port under a reduced pressure and, finally, the feed port is sealed (end sealing). This method is a method which is used also for assembly of liquid crystal cells.

However, the above-mentioned dye-sensitized solar cells in the past have problems as to the end-sealed portion strength and durability, and, in addition, have a shape-basis demerit in that a projection is generated due to the end-sealed portion.

Accordingly, a problem to be solved by the present invention is to provide a method of manufacturing a dye-sensitized photoelectric conversion device by which a dye-sensitized photoelectric conversion device being excellent in strength and durability and free of any projection, owing to the absence of need for end sealing, can be manufactured by simple manufacturing steps, and a dye-sensitized photoelectric conversion device manufactured by the method.

### Disclosure of Invention

In order to solve the above problem, the first-named invention provides
a method of manufacturing a dye-sensitized photoelectric conversion device having an electrolyte between a dye-sensitized semiconductor layer and a counter electrode, a first armor member provided on the outside of the dye-sensitized semiconductor layer, and a second armor member provided on the outside of the counter electrode, the method including the steps of:
forming a sealing material and the electrolyte at predetermined locations of one or both of the first armor member and the second armor member; and
adhering the first armor member and the second armor member to each other with the sealing material in the condition where the sealing material and the electrolyte are sandwiched between the first armor member and the second armor member and under a gas pressure of not higher than the atmospheric air pressure and not lower than the vapor pressure of the electrolyte.

The second-named invention provides
a dye-sensitized photoelectric conversion device including an electrolyte between a dye-sensitized semiconductor layer and a counter electrode, a first armor member provided on the outside of the dye-sensitized semiconductor layer, and a second armor member provided on the outside of the counter electrode, the device being manufactured by sequentially conducting the steps of:
forming a sealing material and the electrolyte at predetermined locations of one or both of the first armor member and the second armor member; and
adhering the first armor member and the second armor member to each other with the sealing material in the condition where the sealing material and the electrolyte are sandwiched between the first armor member and the second armor member and under a gas pressure of not higher than the atmospheric air pressure and not lower than the vapor pressure of the electrolyte.

In the first-named and second-named inventions, the materials and configurations of the first armor member and the second armor member are selected as required. The first armor member, preferably, is a transparent conductive substrate, for example, a transparent substrate having a transparent conductive layer, and, typically, the dye-sensitized semiconductor layer is formed on the transparent conductive substrate. Over the dye-sensitized semiconductor layer, further, the counter electrode may be provided either directly or through a porous insulating layer therebetween. The second armor member is not particularly limited; for example, the second armor member may be a member having the counter electrode formed on a substrate such as a glass substrate and a quartz substrate, or may be a metallic plate. In the case where the first armor member is provided with the dye-sensitized semiconductor layer and the counter electrode, the second armor member is not particularly limited, provided the second armor member is formed from a material having gas barrier properties. As the material having gas barrier properties, for example, a material having an oxygen permeability of not more than 100 cc/m²/day/atm and a water vapor permeability of not more than g/m²/day is used. The gas pressure at the time of adhering the first armor member and the second armor member to each other is not particularly limited insofar as the gas pressure is not higher than the atmospheric air pressure and not lower than the vapor pressure of the electrolyte. In the case of a liquid electrolyte having a vapor pressure, the gas pressure can be lowered around to such a level that boiling of the liquid electrolyte occurs. In addition, it is preferable that at the time of pressure reduction, the atmosphere in the system is preliminarily replaced by an inert gas, and the adhesion is conducted in the inert gas atmosphere. Although the adhering pressure is not limited, curing the sealing material while exerting an appropriate degree of pressure thereon promises an enhanced seal strength. Since the atmospheric air pressure is exerted on the sealing material from the outside of the first armor member and the second armor member upon return to the atmospheric air pressure, however, the exertion of pressure may not necessarily be conducted. The vapor pressure of the electrolyte introduced into the space between the first armor member and the second armor member, preferably, is not more than 100 Pa at 20°C. This is because an electrolyte of which the vapor pressure is higher than 100 Pa cannot endure the reduction in pressure and would be evaporated. Therefore, care must be taken in the case where the electrolyte contains a solvent. In addition, the electrolyte is preferably in a gelled state. Where the electrolyte is in a gelled state or the like in which it has a certain degree of viscosity, the electrolyte would not get out of shape upon being applied to the first armor member or the second armor member, so that mixing of the electrolyte with the sealing material can be obviated. The sealing material is not particularly limited; preferably, however, a UV (ultraviolet)-curing adhesive is used. As for the methods for forming the sealing material and the electrolyte, known wet-type coating methods such as various printing methods, application by a dispenser, and blade coating can be used in the case where these materials are liquid. Among others, screen printing and application by a dispenser in which the coating amount and the coating pattern can be controlled precisely are preferred. In the case where the electrolyte contains a matrix such as a polymer, dilution of the electrolyte with a plasticizer or the like and evaporating-off of the plasticizer or the like after coating may be conducted, as required. The sealing material and the electrolyte may be formed on either of the first armor member side and the second armor member side. The sealing material and the electrolyte may both be formed on the first armor member, or they may both be formed on the second armor member, or one of the sealing material and the electrolyte may be formed on the first armor member or the second armor member whereas the other may be formed on the second armor member or the first armor member, before adhering the first armor member and the second armor member to each other. Further, in the case of a dye-sensitized photoelectric conversion device with a monolithic structure in which, for example, the first armor member is a transparent conductive substrate and the dye-sensitized semiconductor layer and the counter electrode layer are all layered on the substrate, the second armor member may be a film of a plastic or the like.

The dye-sensitized semiconductor layer, typically, is provided on a transparent conductive substrate. The transparent conductive substrate may either be a conductive or non-conductive transparent support substrate with a transparent conductive film formed thereon or be a transparent substrate which is entirely conductive. The material of the transparent support substrate is not particularly limited, and various base materials can be used, provided they are transparent. The transparent support substrate, preferably, is excellent in barrier properties against moisture and gases which might penetrate from the outside of the dye-sensitized photoelectric conversion device, and excellent in solvent resistance, weather resistance and the like. Specific examples of the transparent support substrate include transparent inorganic substrates of quartz, sapphire, glass, etc., and transparent plastic substrates of polyethylene terephthalate, polyethylene naphthalate, polycarbonate, polystyrene, polyethylene, polypropylene, polyphenylene sulfide, polyvinylidene cluoride, tetraacetylcellulose, brominated phenoxy, aramids, polyimides, polystyrenes, polyarylates, polysulfones, polyolefins, etc., among which particularly preferred are substrates having high transmittance for light in the visible region, but these are not limitative. The transparent support substrate is preferably a transparent plastic substrate, taking into account processibility, lightweightness and the like. In addition, the thickness of the transparent support substrate is not particularly limited, and can be freely selected according to such factors as light transmittance and properties as barrier between the inside and the outside of the dye-sensitized photoelectric conversion device.

As for the surface resistance (sheet resistance) of the transparent conductive substrate, a lower value is more preferable. Specifically, the surface resistance is preferably not more than 500 Ω/□, more preferably 100 Ω/□. In the case of forming the transparent conductive film on the transparent support substrate, known materials can be used as the material of the transparent conductive film. Specific examples of the materials which can be used include indium tin composite oxide (ITO), fluorine-doped SnO₂ (FTO), antimony-doped SnO₂ (ATO), SnO₂, ZnO, and indium zinc composite oxide (IZO), which are not limitative and which can be used in combination of two or more thereof. Besides, for the purpose of reducing the surface resistance of the transparent conductive substrate and enhancing the current collection efficiency, a wiring of a conductive material such as highly conductive metals, carbon, etc. may be separately provided on the transparent conductive substrate. A conductive material use for forming the wiring is not particularly limited; preferably, however, a conductive material which is high in corrosion resistance and oxidation resistance and low in its own leakage current is desirably used. It should be noted here, however, that even a conductive material which is low in corrosion resistance can be used when a protective layer including a metallic oxide or the like is separately provided thereon. Besides, for the purpose of protecting the wiring from corrosion and the like, the wiring is preferably disposed between the transparent conductive substrate and the protective layer.

The dye-sensitized semiconductor layer, typically, includes semiconductor particulates with a dye supported thereon. As the material of the semiconductor particulates, there can be used not only elemental semiconductors represented by silicon but also various compound semiconductors, perovskite structure compounds and the like. These semiconductors are preferably n-type semiconductors in which conduction-band electrons become carriers under irradiation with light, to give an anode current. Specific examples of these semiconductors include TiO₂, ZnO, WO₃, Nb₂O₅ TiSrO₃, and SnO₂, among which particularly preferable is the anatase-form TiO₂. The kinds of the semiconductors are not limited to the just-mentioned ones, and they can also be used in mixture of two or more of them. Further, the semiconductor particulates may take various forms such as particulate form, tubular form, and rod-like form, as required.

The particle diameter of the semiconductor particulates is not particularly limited; however, the mean particle diameter of primary particles is preferably 1 to 200 nm, particularly preferably 5 to 100 nm. In addition, the semiconductor particulates with such a mean particle diameter may be mixed with semiconductor particulates having a mean particle diameter greater than the just-mentioned, whereby it is possible to scatter the incident light by the semiconductor particulates having the greater mean particle diameter and thereby to enhance quantum yield. In this case, the mean particle diameter of the semiconductor particulates prepared separately for mixing is preferably 20 to 500 nm.

The method for producing the semiconductor layer including the semiconductor particulates is not particularly limited. Taking physical properties, convenience, production cost and the like into consideration, however, a wet-type film forming method is preferred. Specifically, a method is preferred in which a powder or sol of the semiconductor particulates is uniformly dispersed in a solvent such as water and organic solvents to prepare a paste, and the transparent conductive substrate is coated with the paste. The method of coating here is not particularly limited, and known methods can be used. Examples of the coating method which can be used include dipping method, spraying method, wire bar method, spin coating method, roller coating method, blade coating method, gravure coating method, and wet printing methods such as letterpress (relief), offset, gravure, intaglio, rubber plate, and screen printing. In the case where crystalline titanium oxide is used as the material of the semiconductor particulates, the crystalline form is preferably the anatase form, from the viewpoint of photocatalytic activity. The anatase-form titanium oxide may be a commercially available powder, sol or slurry, or, alternatively, anatase-form titanium oxide with a predetermined particle diameter may be prepared by a known method such as hydrolysis of a titanium oxide alkoxide. In the case of using a commercially available powder, it is preferable to dissolve secondary aggregation of the particles, and to disperse the particles by using a mortar, a ball mill, an ultrasonic dispersing apparatus or the like at the time of preparing the coating liquid. In this instance, in order that the particles freed from secondary aggregation are prevented from re-aggregating, acetylacetone, hydrochloric acid, nitric acid, a surfactant, a chelating agent or the like may be added to the coating liquid. Besides, for the purpose of thickening, various thickeners may be added, for example, polymers such as polyethylene oxide, polyvinyl alcohol, etc. or thickeners based on cellulose or the like.

The semiconductor layer including the semiconductor particulates, or the semiconductor particulate layer, preferably has a large surface area so that a large amount of the sensitizing dye can be adsorbed thereon. Therefore, the surface area as measured in the condition where the semiconductor particulate layer is formed on a support body by coating is preferably not less than 10 times, more preferably not less than 100 times, the projected area. The upper limit for the surface area is not specifically restricted, but ordinarily is about 1000 times the projected area. In general, as the thickness of the semiconductor particulate layer increases, the amount of the dye supported per unit projected area increases and the light capture ratio is therefore higher; but, at the same time, the diffusion distance of injected electrons is increased and therefore the loss due to charge recombination is also increased. Accordingly, there is a preferred thickness value for the semiconductor particulate layer. The preferable thickness is generally 0.1 to 100 µm, more preferably 1 to 50 µm, and particularly preferably 3 to 30 µm. The semiconductor particulate layer, after formed on the support body by coating, is preferably baked in order to bring the particles into electronic contact with one another and to enhance the film strength and the adhesion between the layer and the substrate. The range of the baking temperature is not particularly limited. If the temperature is raised too much, however, the resistance of the substrate would be raised, and melting might occur. Therefore, the baking temperature is normally 40 to 700°C, preferably 40 to 650°C. In addition, the baking time also is not particularly limited; normally, the baking time is about 10 min to 10 hr. After the baking, such treatments as chemical plating using an aqueous solution of titanium tetrachloride, a necking treatment using an aqueous solution of titanium trichloride, and a dipping treatment of a semiconductor particulate sol having a diameter of 10 nm or below may be conducted, for the purpose of increasing the surface area of the semiconductor particulate layer and/or enhancing the necking among the semiconductor particulates. In the case of using a plastic substrate as the support body of the transparent conductive substrate, a method may be adopted in which the paste containing a binding agent is applied to the substrate, and press bonding to the substrate is carried out by use of a hot press.

As the dye to be supported in the semiconductor layer, any dye that shows a sensitizing action can be used without any particular limitation. Examples of the dye which can be used include xanthene dyes such as Rhodamine B, Rose Bengale, eosine, erythrosine, etc., cyanine dyes such as merocyanine, quinocyanine, cryptocyanine, etc., basic dyes such as phenosafranine, Cabri Blue, thiocine, Methylene Blue, etc., and porphyrin compounds such as chlorophyll, zinc-porphyrin, magnesium-porphyrin, etc. Other examples include azo dyes, phthalocyanine compounds, coumarin compounds, Ru bipyridine complex compound, Ru terpyridine complex compound, anthraquinone dyes, polycyclic quinone dyes, and squarylium. Among these, the Ru bipyridine complex compound is particularly preferable because of its high quantum yield. However, the sensitizing dye is not limited to the just-mentioned examples, and these sensitizing dyes may be used in mixture of two or more of them.

The method for adsorption of the dye on the semiconductor layer is not particularly limited. For example, the sensitizing dye may be dissolved in a solvent such as alcohols, nitriles, nitromethane, halogenated hydrocarbons, ethers, dimethyl sulfoxide, amides, N-methylpyrrolidone, 1,3-dimethylimidazolidinone, 3-methyloxazolidinone, esters, carboxylic acid esters, ketones, hydrocarbons, water, etc., and the semiconductor layer may be immersed in the dye solution or coated with the dye solution. Besides, in the case of using a highly acidic dye, deoxycholic acid may be added for the purpose of suppressing association among the dye molecules.

After the adsorption of the sensitizing dye, the surface of the semiconductor electrode may be treated with an amine for the purpose of accelerating the removal of an excess of the sensitizing dye adsorbed. Examples of the amine include pyridine, 4-tert-butylpyridine, and polyvinyl pyridine. Where the amine is a liquid, the amine may be used either as it is or in the state of being dissolved in an organic solvent.

As the electrolyte, combinations of iodine (I₂) with a metal iodide or an organic iodide and combinations of bromine (Br₂) with a metal bromide or an organic bromide can be used. Also usable are metal complexes such as ferrocyanate/ferricyanate, ferrocene/ferricinium ion, etc., sulfur compounds such as sodium polysulfide, alkyl thiol/alkyl disulfide, etc., viologen dyes, hydroquinone/quinone, etc. As the cation in the metallic compounds, preferred are Li, Na, K, Mg, Ca, Cs and the like. As the cation in the organic compounds, preferred are quaternary ammonium compounds such as tetraalkylammoniums, pyridiniums, imidazoliums, etc. The just-mentioned examples are nonlimitative examples, and they may also be used in mixture of two or more of them. Among the above-mentioned, those electrolytes in which I₂ is combined with LiI, NaI or a quaternary ammonium compound such as imidazolium iodide are preferred. The concentration of the electrolyte salt, based on the solvent, is preferably 0.05 to 5 M, more preferably 0.2 to 3 M. The concentration of I₂ or Br₂ is preferably 0.0005 to 1 M, more preferably 0.001 to 0.3 M. Besides, additives including an amine compound represented by 4-tert-butylpyridine may be added, for the purpose of enhancing the open-circuit voltage.

Examples of the solvent constituting the electrolyte composition mentioned above include water, alcohols, ethers, esters, ester carbonates, lactones, carboxylic acid esters, triphosphates, heterocyclic compounds, nitriles, ketones, amides, nitromethane, halogenated hydrocarbons, dimethyl sulfoxide, sulfolane, N-methylpyrrolidone, 1,3-dimethylimidazolidinone, 3-methyloxazolidinone, and hydrocarbons, which are not limitative and can also be used in mixture of two or more of them. Further, ionic liquids containing a quaternary ammonium salt based on tetraalkyl, pyridinium, or imidazolium can also be used as solvent.

A gelling agent, a polymer, a crosslinking monomer or the like may be dissolved in the electrolyte composition and inorganic ceramic particles may be dispersed therein to obtain a gelled electrolyte to be used, for the purpose of suppressing liquid leakage from the dye-sensitized photoelectric conversion device and/or suppressing evaporation of the electrolyte. As for the ratio between the gel matrix and the electrolyte composition, as the amount of the electrolyte composition is larger, the mechanical strength is lower although the ionic conductivity is higher. On the contrary, if the amount of the electrolyte composition is too small, the ionic conductivity is lowered although the mechanical strength is high. Therefore, the amount of the electrolyte composition based on the amount of the gelled electrolyte is desirably 50 to 99 wt%, preferably 80 to 97 wt%. Besides, by dissolving the electrolyte and a plasticizer in a polymer and then evaporating off the plasticizer, it is possible to realize an entirely solid type dye-sensitized photoelectric conversion device.

To form the counter electrode, any of conductive materials can be used. Evan an insulating material can be used if a conductive catalyst layer is disposed on the side of facing the dye-sensitized semiconductor layer. It is to be noted here, however, that it is preferable to use an electrochemically stable material as the material of the counter electrode. Specifically, it is desirable to use platinum, gold, carbon, conductive polymer or the like. In addition, for the purpose of enhancing the oxidation-reduction catalytic effect, it is preferable that the counter electrode portion on the side of facing the dye-sensitized semiconductor layer has a fine structure and an increased surface area. For example, that portion of the counter electrode is desirably in a platinum black state in the case where the counter electrode is formed from platinum, and in a porous state in the case where the counter electrode is formed from carbon. The platinum black state can be obtained by anodic oxidation of platinum, a reducing treatment of a platinum compound, or the like method. In addition, the porous-state carbon can be formed by sintering of carbon particulates, baking of an organic polymer or the like method. Besides, by wiring a metal having a high oxidation-reduction catalytic effect such as platinum on the transparent conductive substrate or by reducing a platinum compound on the surface of the substrate, the counter electrode can also be used as a transparent electrode.

In the case where the dye-sensitized photoelectric conversion device has a so-called monolithic structure in which the components are layered on a single transparent substrate and is provided with a porous insulating layer, the material of the porous insulating layer is not particularly limited insofar as it is a non-conductive material. Especially preferred examples of the material include zirconia, alumina, titania, and silica. Preferably, the porous insulating material is composed of particles of such an oxide, and its porosity is not less than 10%. The upper limit of the porosity is not specifically restricted. From the viewpoint of physical strength of the insulating layer, however, the porosity in general is preferably about 10 to 80%. If the porosity is less than 10%, it influences the diffusion of the electrolyte, and would lead to marked lowering in the cell characteristics. Besides, the pore diameter is preferably 1 to 1000 nm. If the pore diameter is less than 1 nm, it influences the diffusion of the electrolyte and the impregnation with the dye, thereby lowering the cell characteristics. Further, if the pore diameter is more than 1000 nm, the catalyst particles in the catalytic electrode layer will penetrate into the insulating layer, thereby possibly causing short-circuit. The method for producing the porous insulating layer is not particularly limited, but it is preferable that the porous insulating layer is a sintered body of the above-mentioned oxide particles.

The method for manufacturing the dye-sensitized photoelectric conversion device is not particularly limited. For example, in the case where the electrolyte composition is liquid or where the electrolyte composition is liquid before introduction thereof and can be gelled in the inside of the photoelectric conversion device, the dye-sensitized semiconductor layer and the counter electrode are opposed to each other, and the substrate portions where the dye-sensitized semiconductor layer is absent so that these electrodes do not contact each other are sealed. In this case, the magnitude of the gap between the dye-sensitized semiconductor layer and the counter electrode is not particularly limited. Normally, the gap is 1 to 100 µm, preferably 1 to 50 µm. If the distance between the electrodes is too long, conductivity is lowered and, hence, the photoelectric current would be reduced. The method of sealing is not particularly limited, but it is preferable to use a light-fast, insulating and moisture-proof material for the sealing. Epoxy resins, UV-curing resins, acrylic adhesives, EVA (ethylene vinyl acetate), ionomer resins, ceramics, various heat fusing films can be used for the sealing, and various welding methods can be used. In addition, the method for injecting a solution of the electrolyte composition is not particularly limited. It is preferable, however, to use a method in which the solution is injected under a reduced pressure into the inside of the cell which has been preliminarily sealed along the outer periphery thereof so as to leave a solution feed port in an open state. In this case, a method in which a several drops of the solution are dripped into the feed port and is injected into the inside of the cell by capillarity is simple and easy to carry out. Besides, the solution injecting operation can also be conducted under a reduced pressure and/or under heating, as required. When the inside of the cell is filled up with the solution, the solution remaining at the feed port is removed, and the feed port is sealed off. The method of sealing in this instance is also not particularly limited. It is also possible to perform the sealing by adhering a glass plate or a plastic substrate with the sealing agent, as required. Besides, other than this method, a method can be used in which adhesion under a reduced pressure is conducted after dropping the electrolyte liquid onto the substrate, like in a liquid crystal drop feeding (ODF; One Drop Filling) step in production of a liquid crystal panel. In addition, in the case of a gelled electrolyte using a polymer or in the case of a wholly solid type electrolyte, a polymer solution containing the electrolyte composition and a plasticizer is supplied onto the dye-sensitized semiconductor layer by casting, followed by evaporating off the liquid components. After removing the plasticizer completely, sealing is conducted in the same manner as above-mentioned. The sealing is preferably carried out in an inert gas atmosphere or under a reduced pressure, by use of a vacuum sealer or the like. After the sealing is over, such operations as heating and pressure application can be conducted, as required, for impregnating the dye-sensitized semiconductor layer with the electrolyte sufficiently.

The dye-sensitized photoelectric conversion device can be fabricated in various shapes according to the intended use thereof, and the shape of the device is not particularly limited.

Most typically, the dye-sensitized photoelectric conversion device is configured as a dye-sensitized solar cell. It should be noted here, however, the dye-sensitized photoelectric conversion device may be other than a dye-sensitized solar cell; for example, it may be a dye-sensitized photosensor or the like.

The dye-sensitized photoelectric conversion device can be used, for example, for a variety of electronic apparatuses. The electronic apparatuses may basically be any ones, and include both portable ones and stationary ones. Specific examples of the electronic apparatuses include cellular phones, mobile apparatuses, robots, personal computers, on-vehicle apparatuses, and various home-use electric appliances and apparatuses. In this case, the dye-sensitized photoelectric conversion device is, for example, a dye-sensitized solar cell which is used as a power supply in any of these electronic apparatuses.

According to the present invention constituted as above-mentioned, the end sealing step required for filling with an electrolyte in the case of a dye-sensitized photoelectric conversion device according to the related art is unnecessitated, and the need to provide a substrate with a feed port for injecting the electrolyte is eliminated. Therefore, lowering in strength and durability due to the provision of such a feed port can be prevented. Further, the problem of generation of a projection is also obviated, owing to the absence of an end-sealed portion.

According to the present invention, a dye-sensitized photoelectric conversion device being excellent in strength and durability and free of any projection can be manufactured through simple manufacturing steps.

### Brief Description of Drawings

[FIG. 1] FIG. 1 is a sectional view of a dye-sensitized photoelectric conversion device according to a first embodiment of the present invention.
[FIG. 2] FIG. 2 is a plan view of the dye-sensitized photoelectric conversion device according to the first embodiment of the present invention.
[FIG. 3] FIG. 3 is a sectional view of the dye-sensitized photoelectric conversion device according to the first embodiment of the present invention.
[FIG. 4] FIG. 4 shows sectional views for illustrating a method of manufacturing the dye-sensitized photoelectric conversion device according to the first embodiment of the present invention.
[FIG. 5] FIG. 5 is a plan view for illustrating the method of manufacturing the dye-sensitized photoelectric conversion device according to the first embodiment of the present invention.
[FIG. 6] FIG. 6 is a sectional view of a major part of a dye-sensitized photoelectric conversion device module according to a second embodiment of the present invention.
[FIG. 7] FIG. 7 is a plan view of a major part of the dye-sensitized photoelectric conversion device module according to the second embodiment of the present invention.
[FIG. 8] FIG. 8 is a sectional view for illustrating a method of manufacturing the dye-sensitized photoelectric conversion device module according to the second embodiment of the present invention.
[FIG. 9] FIG. 9 is a sectional view of a major part of dye-sensitized photoelectric conversion device module according to a third embodiment of the present invention.
[FIG. 10] FIG. 10 is a plan view of a major part of dye-sensitized photoelectric conversion device module according to the third embodiment of the present invention.
[FIG. 11] FIG. 11 is a sectional view of dye-sensitized photoelectric conversion device module according to the third embodiment of the present invention.

### Best Mode for Carrying Out the Invention

Now, embodiments of the present invention will be described below referring to the drawings. Incidentally, in the following embodiments, the same or corresponding parts will be denoted by the same symbols.

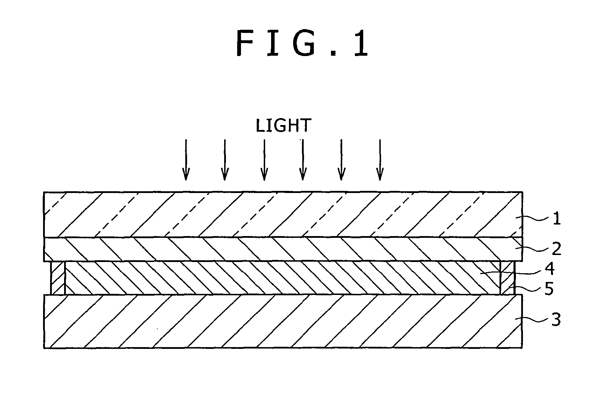

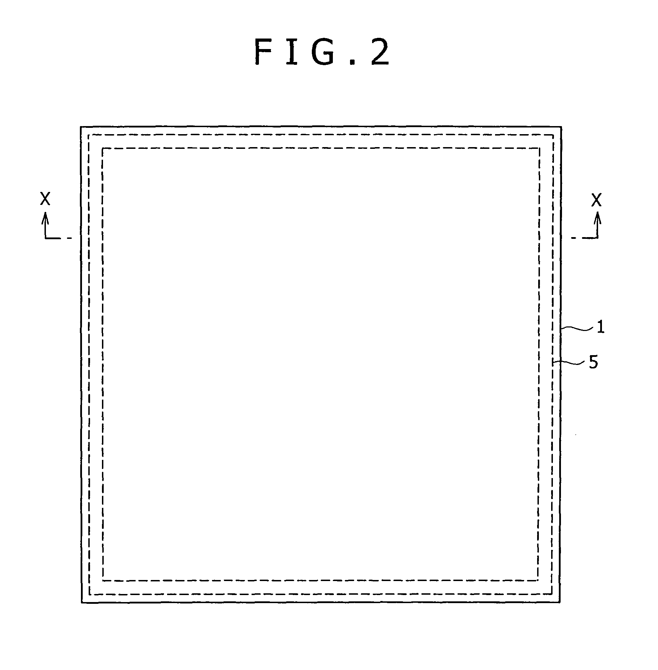

FIG. 1 is a sectional view showing a dye-sensitized photoelectric conversion device according to a first embodiment of the present invention. A plan view of the dye-sensitized photoelectric conversion device in the case where the plan-view shape of the device is square is shown in FIG. 2. FIG. 1 corresponds to a sectional view taken along line X-X of FIG. 2.

As shown in FIGS. 1 and 2, in this dye-sensitized photoelectric conversion device, for example, a transparent conductive substrate 1 with a dye-sensitized semiconductor layer 2 formed thereon and a conductive substrate 3 of which at least a surface constitutes a counter electrode are so disposed that the dye-sensitized semiconductor layer 2 and the conductive substrate 3 are opposed to each other, with a predetermined spacing therebetween, and an electrolyte layer 4 is sealed in the space between them. The vapor pressure of an electrolyte used to form the electrolyte layer 4 is preferably not more than 100 Pa at 20°C. As the dye-sensitized semiconductor layer 2, a layer of semiconductor particulates with a dye supported thereon is used. The electrolyte layer 4 is sealed with a sealing material 5. As the sealing material 5, a UV-curing adhesive or the like is used.

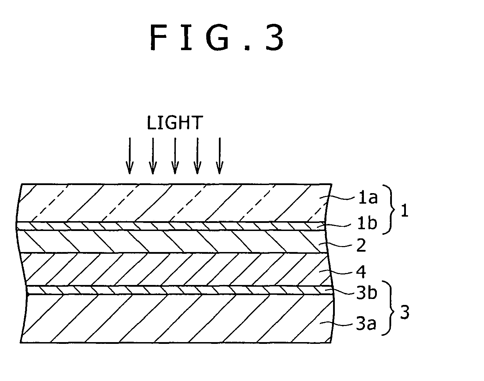

FIG. 3 shows the dye-sensitized photoelectric conversion device, particularly, in the case where the transparent conductive substrate 1 includes a transparent substrate 1a with a transparent electrode 1b formed thereon, and the conductive substrate 3 includes a transparent or opaque substrate 3a with a counter electrode 3b formed thereon.

The transparent conductive substrate 1 (or the transparent substrate 1a and the transparent electrode 1b), the dye-sensitized semiconductor layer 2 and the conductive substrate 3 (or the substrate 3a and the counter electrode 3b) can be selected from among the above-mentioned ones, as required.

Now, a method of manufacturing the dye-sensitized photoelectric conversion device will be described below.

First, a transparent conductive substrate 1 is prepared. Next, a paste containing semiconductor particulates dispersed therein is applied onto the transparent conductive substrate 1 in a predetermined gap size (thickness). Subsequently, the transparent conductive substrate 1 is heated to a predetermined temperature, thereby sintering the semiconductor particulates. Next, the transparent conductive substrate 1 with the semiconductor particulates thus sintered is, for example, immersed in a dye solution so that a sensitizing dye is supported on the semiconductor particulates. In this way, a dye-sensitized semiconductor layer 2 is formed.

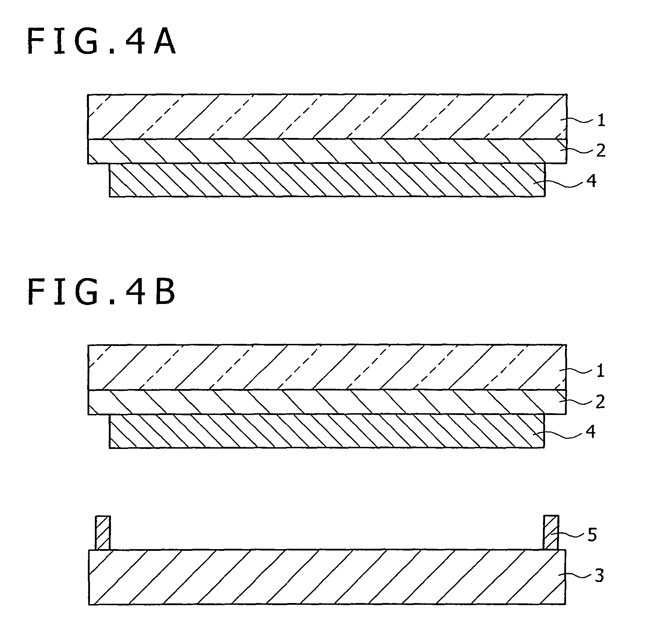

Subsequently, as shown in A of FIG. 4, an electrolyte layer 4 including a gelled electrolyte is formed in a predetermined pattern at a predetermined location on the dye-sensitized semiconductor layer 2.

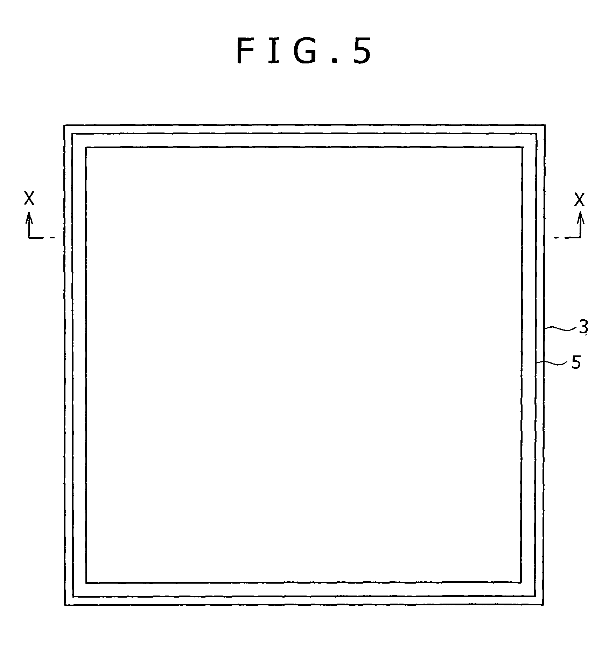

On the other hand, a conductive substrate 3 is separately prepared. Then, as shown in B of FIG. 4, a sealing material 5 is formed in a predetermined pattern at a predetermined location of an outer peripheral part on the conductive substrate 3, and the conductive substrate 3 is opposed to the transparent conductive substrate 1. A plan view of the conductive substrate 3 is shown in FIG. 5. The electrolyte layer 4 is so sized as to be accommodated in the space surrounded by the sealing material 5.

Next, as shown in B of FIG. 4, the transparent conductive substrate 1 and the conductive substrate 3 are adhered to each other with the sealing material 5 in the condition where the sealing material 5 and the electrolyte layer 4 are sandwiched therebetween and under a gas pressure of not higher than the atmospheric air pressure and not lower than the vapor pressure of the electrolyte used to form the electrolyte layer 4. Where a UV-curing adhesive is used as the sealing material 5, it is cured by irradiation with UV light. This adhesion is preferably carried out in an atmosphere of an inert gas such as nitrogen gas and argon gas.

In this manner, the dye-sensitized photoelectric conversion device shown in FIGS. 1 and 2 is manufactured.

Now, operation of the dye-sensitized photoelectric conversion device will be described below.

Light having come from the transparent conductive substrate 1 side and been transmitted through the transparent conductive substrate 1 excites the dye in the dye-sensitized semiconductor layer 2 to generate electrons. The electrons are swiftly handed over to the semiconductor particulates constituting the dye-sensitized semiconductor layer 2. On the other hand, the dye having lost the electrons receive electrons from ions present in the electrolyte layer 4, and the molecules having handed over the electrons receive electrons again at the surface of the conductive substrate 3. By such a series of reactions, an electromotive force is generated between the transparent conductive substrate 1 and the conductive substrate 3, which are electrically connected to the dye-sensitized semiconductor layer 2. In this manner, photoelectric conversion is performed.

As above-mentioned, according to the first embodiment, the dye-sensitized semiconductor layer 2 is formed on the transparent conductive substrate 1, and the electrolyte layer 4 is formed at a predetermined location on the dye-sensitized semiconductor layer 2. In addition, the sealing material 5 is provided at predetermined positions on the conductive substrate 3 of which at least a surface constitutes the counter electrode. The transparent conductive substrate 1 and the conductive substrate 3 are adhered to each other with the sealing material 5 in the condition where the electrolyte layer 4 and the sealing material 5 are sandwiched therebetween and under a gas pressure of not higher than the atmospheric air pressure and not lower than the vapor pressure of the electrolyte used to form the electrolyte layer 4. This ensures that the end sealing step required for filling with the electrolyte in the case of the dye-sensitized photoelectric conversion device according to the related art is unnecessitated, and the need to provide the substrate with an electrolyte feed port is eliminated. Therefore, lowering in strength and durability due to the provision of such a feed port can be prevented. Further, the problem of generation of a projection is also obviated, owing to the absence of an end-sealed portion. Accordingly, a dye-sensitized photoelectric conversion device being excellent in strength and durability and free of any projection can be manufactured by simple manufacturing steps.

Examples of the dye-sensitized photoelectric conversion device will be described.

### Example 1

A transparent conductive substrate was prepared as follows. An FTO substrate (sheet resistance: 10 Ω/□) for use in amorphous solar cell, produced by Nippon Sheet Glass Co., Ltd., was processed into the size of 25 mm × 25 mm × (t) (thickness 1.1 mm), and the processed FTO substrate was then subjected to ultrasonic cleaning by sequentially using acetone, an alcohol, an alkali cleaning liquid, and ultrapure water, followed by drying.

The FTO substrate was coated with a titanium oxide paste, produced by Solaronix, by use of a screen printing machine with a screen mask shaped to have a diameter of 5 mm. In coating with the paste, a 7 µm-thick layer of a transparent Ti-Nanoxide TSP paste and a 13 µm-thick layer of Ti-Nanoxide DSP containing scattering particles were sequentially formed in this order from the FTO substrate side, to obtain a porous titanium oxide film in a total thickness of 20 µm. The porous titanium oxide film was baked in an electric furnace at 500°C for 30 min, and allowed to cool. Thereafter, the porous titanium oxide film was immersed in 0.1 mol/L aqueous solution of TiCl₄, was held in this condition at 70°C for 30 min, washed well with pure water and ethanol, then dried, and again baked in an electric furnace at 500°C for 30 min. In this manner, a TiO₂ sintered body was produced.

Next, the TiO₂ sintered body was immersed in a 0.5 mM solution of cis-bis(isothiocyanato)-N,N-bis(2,2'-dipyridyl-4,4'-dicarboxylato)-ruthenium(II) ditetrabutylammonium salt (N719 dye) in a tert-butyl alcohol/acetonitrile mixed solvent (volume ratio 1:1) at room temperature for 48 hr, so as to support the dye thereon. The electrode thus obtained was washed with acetonitrile, and dried in a dark place. In this manner, a dye-sensitized TiO₂ sintered body was produced.

A counter electrode having a 50 nm-thick Cr layer and a 100 nm-thick Pt layer sequentially formed over a 25 mm × 25 mm × t1.1 mm glass substrate by sputtering was prepared.

The counter electrode was coated with a UV-curing adhesive as a sealing material by screen printing, so as to leave a current collection area, in a size of 20 mm × 20 mm in outer shape and 2 mm in width.

An electrolyte composition was prepared by dissolving 0.045 g of sodium iodide (NaI), 1.11 g of 1-propyl-2,3-dimethylimidazolium iodide, 0.11 g of iodine (I₂), and 0.081 g of 4-tert-butylpyridine in 3 g of propylene carbonate.

To 0.9 g of the electrolyte composition was added 0.1 g of a silica nanopowder, and the resulting mixture was stirred sufficiently by a rotary and revolutionary mixer, to obtain a gelled electrolyte. The gelled electrolyte was applied to the dye-sensitized TiO₂ sintered body on the FTO substrate by a dispenser, and the assembly was introduced into an argon-flushed chamber together with the above-mentioned counter electrode. The dye-sensitized TiO₂ sintered body formed on the FTO substrate and the Pt surface of the counter electrode formed on the glass substrate were opposed to each other, and the pressure inside the chamber was reduced to 100 Pa by a rotary pump. The assembly of the substrates opposed to each other was pressed with a pressure of 1 kg/cm², and, under the pressing, irradiation with UV light was conducted by use of a UV lamp, to cure the UV-curing adhesive. Thereafter, the pressure inside the chamber was returned to the atmospheric air pressure. In this manner, a dye-sensitized photoelectric conversion device in which the gelled electrolyte is filling the gap between the dye-sensitized TiO₂ sintered body and the Pt surface of the counter electrode and the periphery of the gelled electrolyte is sealed with the UV-curing adhesive was obtained.

### Comparative Example 1

A counter electrode formed by sequentially sputtering Cr in a thickness of 50 nm and Pt in a thickness of 100 nm over a 25 mm × 25 mm × t1.1 mm glass substrate provided with a hole of 0.5 mm in diameter was prepared.

A dye-sensitized photoelectric conversion device was fabricated in the same manner as in Example 1, except that the FTO substrate not coated with the gelled electrolyte and the counter electrode were adhered to each other, the electrolyte solution without addition of silica thereto was directly injected through the preliminarily prepared 0.5 mm diameter feed port under a reduced pressure, and then the feed port was sealed with the glass substrate and a UV-curing adhesive.

For the dye-sensitized photoelectric conversion devices fabricated in Example 1 and Comparative Example 1 as above, values of retention factor of photoelectric conversion efficiency as measured under irradiation with pseudo-sunlight (AM 1.5, 100 mW/cm²) after preservation at 60°C for 1000 hr, with the photoelectric conversion efficiency immediately upon fabrication being taken as 100, are shown in Table 1.

**[Table 1]**

| | After preservation for 1000 hr [%] |
|---|---|
| Example 1 | 85.2 |
| Example 2 | 81.6 |
| Example 3 | 83.3 |
| Comparative Example 1 | 43.2 |
| Comparative Example 2 | 35.9 |
| Comparative Example 3 | 43.8 |

It is seen from Table 1 that the dye-sensitized photoelectric conversion device of Example 1 is excellent in durability as it has a photoelectric conversion efficiency retention factor of about 2 times that of the dye-sensitized photoelectric conversion device of Comparative Example 1.

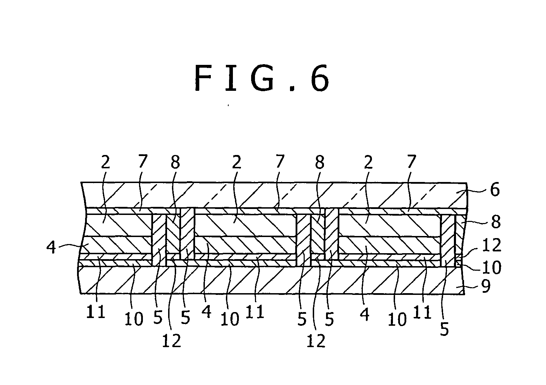

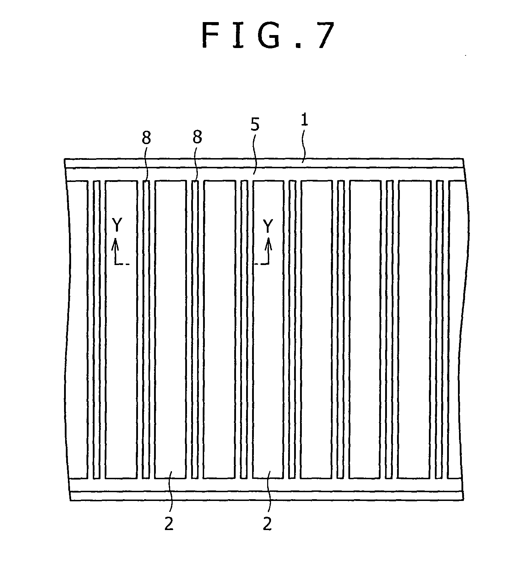

Now, a dye-sensitized photoelectric conversion device module according to a second embodiment of the present invention will be described below. FIG. 6 is a sectional view of the dye-sensitized photoelectric conversion device module. A plan view of the dye-sensitized photoelectric conversion device module in the case where the plan-view shape of the module is a rectangle is shown in FIG. 7. FIG. 6 corresponds to an enlarged sectional view taken along line Y-Y of FIG. 7.

As shown in FIGS. 6 and 7, in the dye-sensitized photoelectric conversion device module, a plurality of stripe-shaped transparent conductive layer 7 are formed in parallel to each other on a non-conductive transparent substrate 6 such as a glass substrate serving as an armor member, stripe-shaped dye-sensitized semiconductor layers 2 extending in the same direction as the transparent conductive layer 7 are formed on the transparent conductive layer 7, and stripe-shaped current collection electrode layers 8 are formed on the transparent conductive layers 7 in areas between the dye-sensitized semiconductor layers 2. On the other hand, stripe-shaped current collection electrode layers 10 are formed on a non-conductive substrate 9, stripe-shaped catalytic electrode layers 11 (counter electrodes) are formed on the current collection electrode layers 10 at positions corresponding to the dye-sensitized semiconductor layers 2, and stripe-shaped current collection electrode layers 12 are formed on the current collection electrode layers 10 at positions corresponding to the current collection electrode layers 8. The two assemblies are so disposed that the dye-sensitized semiconductor layers 2 and the catalytic electrode layers 11 are opposed to each other with a predetermined spacing therebetween, and electrolyte layers 4 are sealed in the spaces therebetween. The vapor pressure of the electrolyte used to form the electrolyte layers 4, preferably, is not more than 100 Pa at 20°C. As the dye-sensitized semiconductor layers 2, layers of semiconductor particulates with a dye supported thereon are used. The electrolyte layers 4 are sealed with a sealing material 5 on the basis of each dye-sensitized photoelectric conversion device. As the sealing material 5, a UV-curing adhesive or the like is used.

The dye-sensitized semiconductor layer 2, the transparent substrate 6, the transparent conductive substrate 7 and the substrate 9 can be selected from among the above-mentioned ones, as required.

Now, a method of manufacturing the dye-sensitized photoelectric conversion device will be described below.

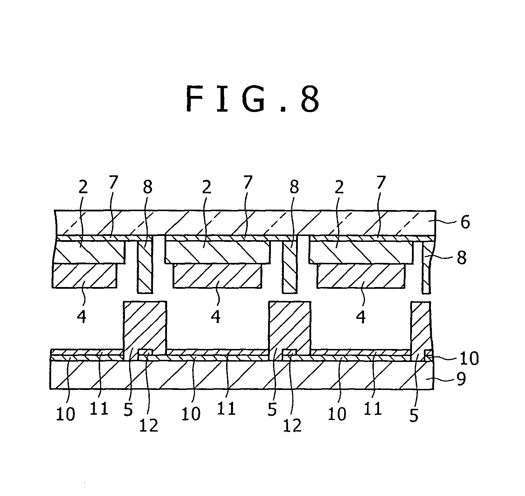

First, as shown in FIG. 8, a transparent substrate 6 is prepared, a transparent conductive layer 7 is formed over the whole surface area of the transparent substrate 6, and the transparent conductive layer 7 is patterned into stripe shapes by etching.

Next, a paste containing semiconductor particulates dispersed therein is applied onto the transparent conductive layers 7 in a predetermined gap. Subsequently, the transparent substrate 6 is heated to a predetermined temperature so as to sinter the semiconductor particulates, thereby forming semiconductor layers composed of sintered bodies of the semiconductor particulates. Then, current collection electrode layers 8 are formed on the transparent conductive layers 7 in areas between the semiconductor layers. Next, the transparent substrate 6 provided thereon with the semiconductor layers composed of the sintered bodies of the semiconductor particulates and with the current collection electrode layers 8 is, for example, immersed in a dye solution so that a sensitizing dye is supported on the semiconductor particulates. In this way, dye-sensitized semiconductor layers 2 are formed on the transparent conductive layers 7.

Subsequently, electrolyte layers 4 composed of a gelled electrolyte are formed in predetermined patterns on the dye-sensitized semiconductor layers 2.

On the other hand, a substrate 9 is separately prepared. Then, as shown in FIG. 8, current collection electrodes 10 are formed on the substrate 9, and, further, catalytic electrode layers 11 and current collection electrode layers 12 are formed on the current collection electrode layers 10. Subsequently, a sealing material 5 is formed on the substrate 9 in an outer peripheral area and in other areas than the catalytic electrode layers 11, and the substrate 9 is opposed to the transparent substrate 6. Each of the electrolyte layers 4 is so sized as to be accommodated in the space surrounded by the sealing material 5.

Next, the transparent substrate 6 and the substrate 9 are adhered to each other with the sealing material 5 in the condition where the sealing material 5 and the electrolyte layers 4 are sandwiched therebetween and under a gas pressure of not higher than the atmospheric air pressure and not lower than the vapor pressure of the electrolyte used to form the electrolyte layers 4. Where a UV-curing adhesive is used as the sealing material 5, it is cured by irradiation with UV light. The adhesion is preferably carried out in an atmosphere of an inert gas such as nitrogen gas and argon gas.

In this manner, the dye-sensitized photoelectric conversion device module shown in FIGS. 6 and 7 is manufactured.

According to the second embodiment, the same merits as those in the first embodiment can be obtained with the dye-sensitized photoelectric conversion device module.

### Example 2

After forming an FTO film on a glass substrate, the FTO film was patterned by etching to form an eight-stripe pattern with 0.5 mm-wide gaps between the stripes. Thereafter, the resulting assembly was subjected to ultrasonic cleaning by sequentially using acetone, an alcohol, an alkali cleaning liquid, and ultrapure water, followed by sufficient drying.

A titanium oxide paste produced by Solaronix was applied onto the glass substrate in an eight-stripe pattern, each stripe measuring 5 mm in width and 40 mm in length (total area: 16 cm²) by use of a screen printing machine. In applying the paste, a 7 µm-thick layer of a transparent Ti-Nanoxide TSP paste and a 13 µm-thick layer of Ti-Nanoxide DSP containing scattering particles were sequentially formed in this order from the glass substrate side, to obtain a porous TiO₂ film in a total thickness of 20 µm. The porous TiO₂ film was baked in an electric furnace at 500°C for 30 min, and allowed to cool. Thereafter, the porous TiO₂ film was immersed in 0.1 mol/L aqueous solution of TiCl₄, was held in this condition at 70°C for 30 min, washed well with pure water and ethanol, then dried, and again baked in an electric furnace at 500°C for 30 min. In this manner, TiO₂ sintered bodies were produced.

Next, using a commercially available silver paste for forming thick films, and by positioning between the TiO₂ sintered bodies, 0.5 mm-wide current collection electrode layers were applied by screen printing. After drying, the current collection electrode layers were baked in a drying atmosphere at 500°C for 30 min in an electric furnace. Thereafter, a light-shielding mask was put on the current collection electrode layers, only the TiO₂ sintered bodies were irradiated with UV light by use of an excimer lamp, and adsorbed impurities were removed. The thickness of the current collection electrode layers upon baking was 40 µm.

Subsequently, the TiO₂ sintered bodies were immersed in a 0.5 mM solution of cis-bis(isothiocyanato)-N,N-bis(2,2'-dipyridyl-4,4'-dicarboxylato)-ruthenium(II) ditetrabutylammonium salt (N719 dye) in a tert-butyl alcohol/acetonitrile mixed solvent (volume ratio 1:1) at room temperature for 48 hr, so as to support the dye thereon. The TiO₂ sintered bodies with the dye supported thereon were washed with acetonitrile, and dried in a dark place. In this manner, a dye-sensitized TiO₂ sintered bodies were produced.

On a quartz substrate prepared as a counter electrode substrate, current collection electrode layers in the same pattern as that of the FTO films on the glass substrate were formed by using a commercially available platinum paste and a screen printing machine. Further, using a commercially available platinum paste, catalytic electrode layers were formed in the same positional relationship as the titanium oxide paste on the glass substrate, and current collection electrode layers were formed in the same positional relationship as the current collection electrode layers on the glass substrate. The electrode layers thus formed were sintered at 1000°C. The thickness of the catalytic electrode layers and the current collection electrode layers upon baking was 5 µm.

A UV-curing adhesive as a sealing material was applied onto the quartz substrate in other areas than the catalytic electrode layers and in an outer peripheral area of the substrate by screen printing.

An electrolyte composition was prepared by dissolving 0.045 g of sodium iodide (NaI), 1.11 g of 1-propyl-2,3-dimethylimidazolium iodide, 0.11 g of iodine (I₂), and 0.081 g of 4-tert-butylpyridine in 3 g of propylene carbonate.

To 0.9 g of the electrolyte composition was added 0.1 g of a silica nanopowder, and the resulting mixture was stirred sufficiently by a rotary and revolutionary mixer, to obtain a gelled electrolyte. The gelled electrolyte was applied to the dye-sensitized TiO₂ sintered bodies on the glass substrate by a dispenser, a light-shielding mask was put on the dye-sensitized TiO₂ sintered bodies from the glass substrate side, and the assembly was introduced into an argon-flushed chamber together with the above-mentioned counter electrodes. The dye-sensitized TiO₂ sintered bodies formed on the glass substrate and the Pt surfaces of the counter electrodes formed on the quartz substrate were opposed to each other, and the pressure inside the chamber was reduced to 100 Pa by a rotary pump. The assembly of the substrates opposed to each other was pressed with a pressure of 1 kg/cm², and, under the pressing, irradiation with UV light was conducted by use of a UV lamp, to cure the UV-curing adhesive. Thereafter, the pressure inside the chamber was returned to the atmospheric air pressure.

In this manner, a dye-sensitized photoelectric conversion device module in which the gelled electrolyte is filling the gaps between the dye-sensitized TiO₂ sintered bodies and the Pt surfaces of the counter electrodes and the periphery of the gelled electrolyte is sealed with the UV-curing adhesive was obtained.

### Comparative Example 2

A dye-sensitized photoelectric conversion device module was fabricated in the same manner as in Example 2, except that a quartz substrate provided with 0.5 mm diameter holes in areas corresponding respectively to the dye-sensitized photoelectric conversion devices was used as the counter electrode substrate, the glass substrate not coated with the gelled electrolyte and the counter electrode substrate were adhered to each other, the electrolyte solution without addition of silica thereto was directly injected through the preliminarily prepared 0.5 mm diameter feed ports under a reduced pressure, and then the feed ports were sealed with the quartz substrate and a UV-curing adhesive.

For the dye-sensitized photoelectric conversion device modules fabricated in Example 2 and Comparative Example 2 as above, values of retention factor of photoelectric conversion efficiency as measured under irradiation with pseudo-sunlight (AM 1.5, 100 mW/cm²) after preservation at 60°C for 1000 hr, with the photoelectric conversion efficiency immediately upon fabrication being taken as 100, are shown in Table 1.

It is seen from Table 1 that the dye-sensitized photoelectric conversion device module of Example 2 is excellent in durability as it has a photoelectric conversion efficiency retention factor of not less than about 2 times that of the dye-sensitized photoelectric conversion device module of Comparative Example 2.

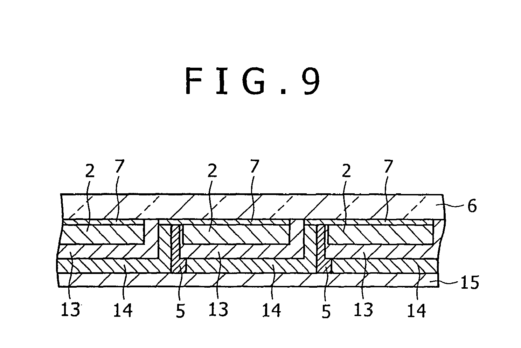

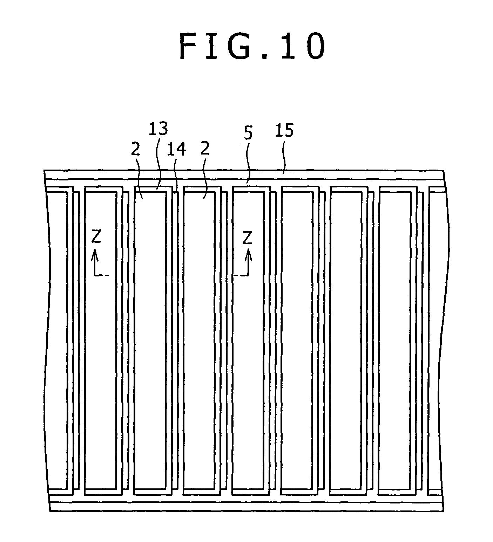

Now, a dye-sensitized photoelectric conversion device module according to a third embodiment of the present invention will be described below. FIG. 9 is a sectional view of the dye-sensitized photoelectric conversion device module. A plan view of the dye-sensitized photoelectric conversion device module in the case where the plan-view shape of the module is a rectangle is shown in FIG. 10. FIG. 9 corresponds to a sectional view taken along line Z-Z of FIG. 9.

As shown in FIGS. 9 and 10, in the dye-sensitized photoelectric conversion device module, a plurality of stripe-shaped transparent conductive layers 7 are provided in parallel to each other on a non-conductive transparent substrate 6 such as a glass substrate serving as an armor member. Over each of the transparent conductive layer 7, there are sequentially formed a dye-sensitized semiconductor layer 2, a porous insulating layer 13 and a counter electrode layer 14 which are stripe-shaped and extending in the same direction as the transparent conductive layer 7. As the dye-sensitized semiconductor layer 2, a layer of semiconductor particulates with a dye supported thereon is used. The dye-sensitized semiconductor layer 2, the porous insulating layer 13 and the counter electrode layer 14 are wholly impregnated with an electrolyte. The vapor pressure of the electrolyte is preferably not more than 100 Pa at 20°C. In this case, the dye-sensitized semiconductor layer 2 is smaller in width than the transparent conductive layer 7, and is exposed at its portion adjacent to one longitudinal edge of the transparent conductive layer 7. The porous insulating layer 13 is greater in width than the dye-sensitized semiconductor layer 2, and is so provided as to cover the whole part of the dye-sensitized semiconductor layer 2. One end of the porous insulating layer 13 is in contact with the transparent substrate 6, and the other end is in contact with the transparent conductive layer 7. One end of the counter electrode layer 14 of one dye-sensitized photoelectric conversion device is connected to the transparent conductive layer 7 of the adjacent dye-sensitized photoelectric conversion device.

A sealing material 5 is provided at each portion between the counter electrode layer 14 of each dye-sensitized photoelectric conversion device and the porous insulating layer 13 of the adjacent dye-sensitized photoelectric conversion device, and on an outer peripheral portion of the substrate, whereby sealing is achieved on the basis of each dye-sensitized photoelectric device. As the sealing material 5, a UV-curing adhesive or the like is used. In addition, an armor member 15 is adhered by the sealing material 5.

The dye-sensitized semiconductor layer 2, the transparent substrate 6, the transparent conductive layer 7, the porous insulating layer 13, the counter electrode layer 14 and the armor member 15 can be selected from among the above-mentioned ones, as required.

Now, a method of manufacturing the dye-sensitized photoelectric conversion device module will be described below.

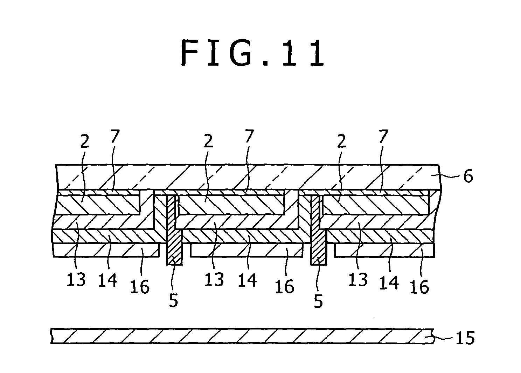

First, as shown in FIG. 11, a transparent substrate 6 is prepared. A transparent conductive layer 7 is formed over the whole surface area of the transparent substrate 6, and thereafter the transparent conductive layer 7 is patterned into stripe shapes by etching.

Next, a paste containing semiconductor particulates dispersed therein is applied in a predetermined gap onto each of the transparent conductive layers 7. Subsequently, the transparent substrate 6 is heated to a predetermined temperature to sinter the semiconductor particulates, thereby forming semiconductor layers composed of sintered bodies of the semiconductor particulates. Then, porous insulating layers 13 are formed on the semiconductor layers. Next, the transparent substrate 6 provided with the semiconductor layers composed of the sintered bodies of the semiconductor particulates and with the porous insulating layers 13 is, for example, immersed in a dye solution, whereby a sensitizing dye is supported on the semiconductor particulates. In this manner, a dye-sensitized semiconductor layer 2 is formed on each of the transparent conductive layers 7.

Subsequently, a counter electrode layer 14 is formed on each of the porous insulating layers 13.

Then, a gelled electrolyte 16 is formed in predetermined patterns in predetermined areas on the counter electrode layers 14.

Next, a sealing material 5 is formed in areas between the adjacent pairs of the porous insulating layers 13 and the counter electrode layers 14 on the transparent substrate 6 and on an outer peripheral portion of the substrate.

Subsequently, the transparent substrate 6 and the armor member 15 are adhered to each other with the sealing material 5 in the condition where the sealing material 5 and the gelled electrolyte 16 are sandwiched therebetween and under a gas pressure of not higher than the atmospheric air pressure and not lower than the electrolyte used to form the gelled electrolyte 16. Besides, the dye-sensitized semiconductor layers 2, the porous insulating layers 13 and the counter electrode layers 14 are impregnated with the electrolyte. As the sealing material 5, a UV-curing adhesive is used, for example. The adhesion is preferably carried out in an atmosphere of an inert gas such as nitrogen gas and argon gas.

In this manner, the dye-sensitized photoelectric conversion device module shown in FIGS. 9 and 10 is manufactured.

According to the third embodiment, the same merits as those in the first embodiment can be obtained with the dye-sensitized photoelectric conversion device module.

### Example 3

After forming an FTO film on a glass substrate, the FTO film was patterned by etching to form an eight-stripe pattern. Thereafter, the resulting assembly was subjected to ultrasonic cleaning by sequentially using acetone, an alcohol, an alkali cleaning liquid, and ultrapure water, followed by sufficient drying.

A titanium oxide paste produced by Solaronix was applied onto the glass substrate in a pattern of eight stripes, each measuring 5 mm in width and 40 mm in length (total area: 16 cm²), by use of a screen printing machine. In applying the paste, a 7 µm-thick layer of a transparent Ti-Nanoxide TSP paste and a 13 µm-thick layer of Ti-Nanoxide DSP containing scattering particles were sequentially formed in this order from the glass substrate side, to obtain porous titanium oxide films in a total thickness of 20 µm. The porous titanium oxide films were baked in an electric furnace at 500°C for 30 min, and allowed to cool. Thereafter, the porous titanium oxide films were immersed in 0.1 mol/L aqueous solution of TiCl₄, were held in this condition at 70°C for 30 min, washed well with pure water and ethanol, then dried, and again baked in an electric furnace at 500°C for 30 min. In this manner, TiO₂ sintered bodies were produced.

Next, as an insulating layer, a screen printing paste prepared from commercially available titanium oxide particles (particle diameter: 200 nm), terpineol and ethyl cellulose was applied onto each of the TiO₂ sintered bodies in a length of 41 mm, a width of 5.5 mm and a thickness of 10 µm. After drying the paste, a screen printing paste prepared from commercially available carbon black and graphite particles, terpineol and ethyl cellulose was applied as a counter electrode layer onto each insulating layer in a length of 40 mm, a width of 6 mm and a thickness of 30 µm, and baked in an electric furnace at 450°C for 30 min. In this manner, the porous insulating layers and the counter electrode layers were formed.

Subsequently, the TiO₂ sintered bodies were immersed in a 0.5 mM solution of cis-bis(isothiocyanato)-N,N-bis(2,2'-dipyridyl-4,4'-dicarboxylato)-ruthenium(II) ditetrabutylammonium salt (N719 dye) in a tert-butyl alcohol/acetonitrile mixed solvent (volume ratio 1:1) at room temperature for 48 hr, so as to support the dye thereon. The TiO₂ sintered bodies with the dye supported thereon were washed with acetonitrile, and dried in a dark place. In this manner, dye-sensitized TiO₂ sintered bodies were produced.

The glass substrate was coated with a UV-curing adhesive in other areas than the dye-sensitized photoelectric conversion devices and in an outer peripheral area of the substrate by screen printing, whereby each of the dye-sensitized photoelectric conversion devices was partitioned by the UV-curing adhesive.

An electrolyte composition was prepared by dissolving 0.045 g of sodium iodide (NaI), 1.11 g of 1-propyl-2,3-dimethylimidazolium iodide, 0.11 g of iodine (I2), and 0.081 g of 4-tert-butylpyridine in 3 g of propylene carbonate.

To 0.9 g of the electrolyte composition was added 0.1 g of a silica nanopowder, and the resulting mixture was stirred sufficiently by a rotary and revolutionary mixer, to obtain a gelled electrolyte. The gelled electrolyte was applied to the porous Pt layers on the dye-sensitized TiO₂ sintered bodies on the glass substrate by a dispenser, a light-shielding mask was put on the dye-sensitized TiO₂ sintered bodies from the glass substrate side, and the assembly was introduced into an argon-flushed chamber together with a cover glass. The gelled electrolyte formed on the glass substrate and the cover glass were opposed to each other, and the pressure inside the chamber was reduced to 100 Pa by a rotary pump. The assembly of the components opposed to each other was pressed with a pressure of 1 kg/cm ² and, under the pressing, irradiation with UV light was conducted by use of a UV lamp, to cure the UV-curing resin. Thereafter, the pressure inside the chamber was returned to the atmospheric air pressure.

In this manner, a dye-sensitized photoelectric conversion device module in which the dye-sensitized TiO₂ sintered bodies, the porous insulating layers and the counter electrode layers are impregnated with the electrolyte and the peripheries of these components are sealed with the UV-curing adhesive was obtained.

### Comparative Example 3

A dye-sensitized photoelectric conversion device module was fabricated in the same manner as in Example 3, except that a glass substrate provided with 0.5 mm diameter holes in areas corresponding respectively to the dye-sensitized photoelectric conversion devices was used as the cover glass, the glass substrate not coated with the gelled electrolyte and the cover glass were adhered, an electrolyte solution without addition of silica thereto was directly injected through the preliminarily prepared 0.5 mm diameter feed ports under a reduced pressure, and then the feed ports were sealed off with the glass substrate and a UV-curing adhesive.

For the dye-sensitized photoelectric conversion device modules fabricated in Example 3 and Comparative Example 3 as above, values of retention factor of photoelectric conversion efficiency as measured under irradiation with pseudo-sunlight (AM 1.5, 100 mW/cm²) after preservation at 60°C for 1000 hr, with the photoelectric conversion efficiency immediately upon fabrication being taken as 100, are shown in Table 1.

It is seen from Table 1 that the dye-sensitized photoelectric conversion device of Example 3 is excellent in durability as it has a photoelectric conversion efficiency retention factor of about 2 times that of the dye-sensitized photoelectric conversion device of Comparative Example 3.

Now, a dye-sensitized photoelectric conversion device according to a fourth embodiment of the present invention will be described below.

This dye-sensitized photoelectric conversion device differs from the dye-sensitized photoelectric conversion device according to the first embodiment in that the electrolyte layer 4 is composed of an electrolyte composition which contains iodine and contains a compound having at least one isocyanate group (-NCO), the compound preferably further containing in its molecule at least one nitrogen-containing functional group other than the isocyanate group, or which further contains another compound having at least one nitrogen-containing functional group other than the isocyanate group-containing compound. The compound having at least one isocyanate group (-NCO) is not particularly limited, but it is preferably compatible with the solvent of the electrolyte, the electrolyte salt and other additives. The compound having at least one nitrogen-containing functional group is preferably an amine compound, but is not limited to an amine compound. The amine compound is not particularly limited, but it is preferably compatible with the solvent of the electrolyte, the electrolyte salt and other additives. When the nitrogen-containing functional group is thus coexisting with the compound having at least one isocyanate group, it greatly contributes particularly to an increase in the open-circuit voltage of the dye-sensitized photoelectric conversion device. Specific examples of the compound having at least one isocyanate group include phenyl isocyanate, 2-chloroethyl isocyanate, m-chlorophenyl isocyanate, cyclohexyl isocyanate, o-tolyl isocyanate, p-tolyl isocyanate, n-hexyl isocyante, 2,4-tolylene diisocyanate, hexamethylene diisocyanate, and 4,4'-methylenediphenyl diisocyanate, which are not limitative. Besides, specific examples of the amine compound include 4-tert-butylpyridine, aniline, N,N-dimethylaniline, and N-methylbenzimidazole, which are not limitative.

The other points than the above-mentioned are the same as those of the dye-sensitized photoelectric conversion device according to the first embodiment.

According to the fourth embodiments, not only the same merits as those of the first embodiments but also other merits can be obtained. Specifically, since the electrolyte layer 4 is composed of an electrolyte composition containing a compound having at least one isocyanate group, both the short-circuit current and the open-circuit voltage can be increased. As a result, it is possible to obtain a dye-sensitized photoelectric conversion device which is extremely high in photoelectric conversion efficiency.

### Example 4

A dye-sensitized photoelectric conversion device was obtained in the same manner as in Example 1, except that in preparing the electrolyte composition, 0.071 g (0.2 mol/L) of phenyl isocyanate was dissolved in 3 g of propylene carbonate in addition to 0.045 g of sodium iodide (NaI), 1.11 g of 1-propyl-2,3-dimethylimidazolium iodide, 0.11 g of iodine (I₂), and 0.081 g of 4-tert-butylpyridine.

While the embodiments and examples of the present invention have been described above, the invention is not limited to the above-described embodiments and examples, and various modifications are possible based on the technical thought of the invention.

For example, the numerical values, structures, shapes, materials, raw materials, processes, etc. mentioned in the embodiments and examples above are merely examples, and numerical values, structures, shapes, materials, raw materials, processes, etc. different from the above-mentioned may be used.

## Claims

1. A method of manufacturing a dye-sensitized photoelectric conversion device having an electrolyte between a dye-sensitized semiconductor layer and a counter electrode, a first armor member provided on the outside of said dye-sensitized semiconductor layer, and a second armor member provided on the outside of said counter electrode, said method comprising the steps of:
forming a sealing material and said electrolyte at predetermined locations of one or both of said first armor member and said second armor member; and
adhering said first armor member and said second armor member to each other with said sealing material in the condition where said sealing material and said electrolyte are sandwiched between said first armor member and said second armor member and under a gas pressure of not higher than the atmospheric air pressure and not lower than the vapor pressure of said electrolyte.

2. The method of manufacturing the dye-sensitized photoelectric conversion device according to claim 1, wherein said first armor member is a transparent conductive substrate.

3. The method of manufacturing the dye-sensitized photoelectric conversion device according to claim 2, wherein said dye-sensitized semiconductor layer is formed on said transparent conductive substrate.

4. The method of manufacturing the dye-sensitized photoelectric conversion device according to claim 1, wherein the vapor pressure of said electrolyte is not more than 100 Pa at 20°C.

5. The method of manufacturing the dye-sensitized photoelectric conversion device according to claim 1, wherein said electrolyte is a gelled electrolyte.

6. The method of manufacturing the dye-sensitized photoelectric conversion device according to claim 1, wherein said sealing material is an ultraviolet-curing adhesive.

7. The method of manufacturing the dye-sensitized photoelectric conversion device according to claim 1, wherein said first armor member and said second armor member are adhered to each other in an inert gas atmosphere.

8. A dye-sensitized photoelectric conversion device including an electrolyte between a dye-sensitized semiconductor layer and a counter electrode, a first armor member provided on the outside of said dye-sensitized semiconductor layer, and a second armor member provided on the outside of said counter electrode, said device being manufactured by sequentially conducting the steps of:
forming a sealing material and said electrolyte at predetermined locations of one or both of said first armor member and said second armor member; and
adhering said first armor member and said second armor member to each other with said sealing material in the condition where said sealing material and said electrolyte are sandwiched between said first armor member and said second armor member and under a gas pressure of not higher than the atmospheric air pressure and not lower than the vapor pressure of said electrolyte.
